(19) Europäisches Patentamt
European Patent Office
Office européen des brevets

(11) Veröffentlichungsnummer: **0 192 167**
**A1**

(12) # EUROPÄISCHE PATENTANMELDUNG

(21) Anmeldenummer: 86101721.8

(22) Anmeldetag: 11.02.86

(51) Int. Cl.[4]: C 08 F 2/50
G 03 C 1/68

(30) Priorität: 21.02.85 DE 3505998

(43) Veröffentlichungstag der Anmeldung: 27.08.86 Patentblatt 86/35

(84) Benannte Vertragsstaaten: AT BE CH DE FR GB IT LI NL SE

(71) Anmelder: **Merck Patent Gesellschaft mit beschränkter Haftung**
**Frankfurter Strasse 250**
**D-6100 Darmstadt(DE)**

(72) Erfinder: **Herz, Klaus Peter, Dr.**
**Berghalde 20**
**D-6900 Heidelberg 1(DE)**

(72) Erfinder: **Köhler, Manfred, Dr.**
**Hebbelstrasse 38**
**D-6100 Darmstadt(DE)**

(72) Erfinder: **Ohngemach, Jörg, Dr.**
**Taubenstrasse 6**
**D-6107 Reinheim 5(DE)**

(54) **Verwendung thiosubstituierter Ketone als Photoinitiatoren.**

(57) Thiosubstituierte Ketone der allgemeinen Formeln I und/oder II

$$(R^1S)_m-Ar^1-(Z-Ar^2)_n-CO-R^2 \qquad I$$

$$(R^1S)_m-Ar^1-CO-R^3-CO-Ar^{1'}-(R^{1'}S)_{m'} \qquad II$$

mit der in Patentanspruch 1 für $R^1$, $R^{1'}$, $R^2$, $R^3$, $Ar^1$, $Ar^{1'}$, $Ar^2$, Z, m, m' und n angegebenen Bedeutung, eignen sich als Initiatoren für die Photopolymerisation ungesättigter Verbindungen.

EP 0 192 167 A1

Merck Patentgesellschaft
mit beschränkter Haftung
6100 D a r m s t a d t

Verwendung von thiosubstituierten Ketonen als Photoinitiatoren.

Die Erfindung betrifft die Verwendung von thiosubstituierten Ketonen als Photoinitiatoren, insbesondere für die Photopolymerisation ethylenisch ungesättigter Verbindungen sowie photopolymerisierbare Systeme enthaltend solche Ketone.

Photochemisch initiierte Polymerisationsreaktionen haben in der Technik große Bedeutung erlangt, insbesondere wenn es um eine schnelle Härtung von dünnen Schichten geht, wie z. B. bei der Härtung von Lack- und Harzüberzügen auf Papier, Metall und Kunststoff oder bei der Trocknung von Druckfarben, da diese Verfahren sich gegenüber konventionellen Methoden zum Bedrucken und Beschichten von Gegenständen durch Rohstoff- und Energieersparnis und eine geringere Umweltbelastung auszeichnen. Da bei diesen Reaktionen in der Regel keiner der Reaktionspartner in der Lage ist, die photochemisch wirksame Strahlung in ausreichendem Maße zu absorbieren, müssen sogenannte Photoinitiatoren zugesetzt werden, die an der gewüschten Reaktion nicht teilnehmen, aber in der Lage sind, eingestrahltes Licht oder UV-Strahlen zu absorbieren, die dabei aufgenommene Energie auf einen der Reaktionspartner zu übertragen und so aktive Starterradikale zu bilden, die

ihrerseits die Photopolymerisation auslösen. Wesentliche Kriterien für die Auswahl solcher Initiatoren sind unter anderem die Art der durchzuführenden Reaktion, das Verhältnis des Absorptionsspektrums des Initiators zur spektralen Energieverteilung der verfügbaren Strahlenquelle, die Löslichkeit des Initiators in der Reaktionsmischung, die Dunkellagerstabilität des mit dem Initiator versetzten Reaktionssystems sowie die Beeinflussung der Endprodukte durch darin verbliebene Reste des Initiators und/oder der daraus während der photochemischen Reaktion entstandenen Produkte. Insbesondere die Geschwindigkeit der Reaktion hängt stark vom verwendeten Initiator ab. Deshalb hat es nicht an Versuchen gefehlt, neue Initiatoren zu suchen, die in ihrem Vermögen, die Photopolymerisation ethylenisch ungesättigter Verbindungen bzw. die Härtung photopolymerisierbarer Systeme zu initiieren, eine gesteigerte Reaktivität zeigen.

Als Initiatoren für die Photopolymerisation ungesättigter Verbindungen sind bisher hauptsächlich Benzophenonderivate, Benzoinether, Benzilketale, Dibenzosuberonderivate, Anthrachinone, Xanthone, Thioxanthone und $\alpha$-Halogenacetophenonderivate eingesetzt worden. Die technische Anwendbarkeit dieser Substanzen wird jedoch durch eine Reihe von Nachteilen deutlich eingeschränkt. Hierzu gehören u. a. geringe Dunkellagerstabilität von vielen photopolymerisierbaren Systemen, die mit diesen Initiatoren versetzt sind, geringe chemische Stabilität und zu geringe Reaktivität im Vermögen, die Photopolymerisation ethylenisch ungesättigter Verbindungen bzw. die Härtung photopolymerisierbarer Systeme zu initiieren. Viele dieser bekannten Initiatoren bewirken eine Vergilbung der mit ihnen hergestellten Polymerisate, die besonders bei der Beschichtung heller Untergrundmaterialien und bei UV- gehärteten Druckfarben höchst unerwünscht ist. Für

dieses zuletzt genannte Anwendungsgebiet ist auch die oft geringe Löslichkeit der bekannten Initiatoren in dem photopolymerisierbaren System ein großer Nachteil. Da Druckfarben in der Regel beträchtliche Mengen farbiger Pigmente enthalten, die einen großen Teil der eingestrahlten Energie absorbieren, ohne daß dieser photochemisch wirksam wird, muß hier eine größere Menge Initiator zugesetzt werden. Sie beträgt hier häufig 5 bis 10 Gewichtsprozent des Reaktionsgemisches, d.h. der Druckfarbe, während sonst in der Kunststoffindustrie in Abwesenheit färbender Zusätze oft 1 bis 2 Gewichtsprozent völlig ausreichend sind. Diese Konzentration läßt sich zumeist auch mit den wenig löslichen bekannten Initiatoren noch erreichen. Bei den in Druckfarben erforderlichen Konzentrationen kristallisieren die bekannten Initiatoren häufig teilweise aus; abgesehen davon, daß die auskristallisierten Anteile nicht mehr initiierend wirksam werden, beschädigen die entstandenen Kristallite auch noch nach einiger Zeit die aus relativ weichen Materialien bestehenden Druckplatten.

Weiterhin werden in den deutschen Offenlegungsschriften 22 61 383 und 27 30 462 Dialkoxyacetophenone und in der DE-OS 27 22 264 eine Reihe von Hydroxyalkylphenonen als Photoinitiatoren beschrieben, die die Nachteile der bis dahin bekannten Initiatoren in wesentlich geringerem Maße aufweisen. Diese zum Teil flüssigen Verbindungen sind in den üblichen photopolymerisierbaren Systemen deutlich besser löslich als die meisten bis dahin bekannten, in der Regel festen Initiatoren und besitzen eine gute Dunkellager- und chemische Stabilität. Insbesondere aber wird bei der Photopolymerisation mit diesen Initiatoren Vergilbung der Polymerisate nur in wesentlich geringerem Ausmaß als bei den bis dahin gebräuchlichen Initiatoren beobachtet. Doch trotz der

gesteigerten photoinitiierenden Wirksamkeit dieser Dialkoxyacetophenone und Hydroxyalkylphenone im Vergleich zu den übrigen bekannten Initiatoren weisen auch diese Verbindungen aufgrund der unvorteilhaften Lage und Größe ihres für die optimale Ausnutzung der eingestrahlten Lichtenergie bedeutsamen Absorptionsmaximums noch eine ungenügende Reaktivität bei der Intiierung der Photopolymerisation pigmentierter Systeme auf. Dadurch sind immer noch relativ lange Härtungszeiten erforderlich, was zu einer nicht optimalen Ausnutzung der UV-Bestrahlungsanlagen führt.

Schließlich führt auch die Vergilbung der mit diesen bekannten Photoinitiatoren ausgehärteten Polymerbeschichtungen zu Problemen durch Farbverfälschungen vor allem beim Einsatz pigmentierter Systeme wie Weißpigmente oder Druckfarben.

Es bestand daher die Aufgabe, Photoinitiatoren, insbesondere für die Photopolymerisation ethylenisch ungesättigter Verbindungen bzw. für die Härtung photopolymerisierbarer Systeme zu finden, die physiologisch unbedenklich sind, im Gemisch mit den anderen Reaktionspartnern eine ausreichende Dunkellagerstabilität besitzen, die selbst oder durch ihre Folgeprodukte keine Vergilbung der Reaktionsprodukte verursachen, die in den üblichen photopolymerisierbaren Systemen eine möglichst hohe Löslichkeit aufweisen, die bei den mit ihnen erhaltenen Beschichtungen eine wesentlich geringere Oberflächenklebrigkeit verursachen und die dabei eine größtmögliche Reaktivität in ihrem Vermögen, die Vergilbungsfreie Härtung photopolymerisierbarer Systeme, besonders die pigmentierter Systeme zu initiieren, zeigen und so bereits in geringen Einsatzkonzentrationen wirksam sind.

Diese Aufgabe wurde gelöst durch die Bereitstellung von thiosubstituierten Ketonen, die im Vergleich zu den bisher bekannten Photoinitiatoren eine gesteigerte Reaktivität in ihrem Vermögen, die vergilbungsfreie Härtung photopolymerisierbarer Systeme, besonders die pigmentierter Systeme zu initiieren, zeigen. Darüberhinaus besitzen die erfindungsgemäßen Verbindungen im Gemisch mit den anderen Reaktionspartnern eine gute Dunkellagerstabilität; sie haben ein breiteres Absorptionsspektrum, was zu einer besseren Ausnutzung der von der Bestrahlungsquelle ausgesandten Lichtenergie führt und ermöglichen die Verwendung dotierter Lampen als Bestrahlungsquellen aufgrund von bathochromen Verschiebungen des Absorptionsmaximums der erfindungsgemäßen Verbindungen. Die unter Verwendung dieser Initiatoren erhaltenen Beschichtungen weisen eine wesentlich geringere Oberflächenklebrigkeit auf als jene mit herkömmlichen Photoinitiatoren erhaltenen Beschichtungen. Außerdem zeichnen sich die mit Hilfe der erfindungsgemäßen Verbindungen ausgehärteten Polymere durch völlig fehlende oder nur sehr geringe Neigung zur Vergilbung aus.

Gegenstand der Erfindung ist somit die Verwendung von thiosubstituierten Ketonen der allgemeinen Formeln I und/oder II

$$(R^1S)_m\text{-}Ar^1\text{-}(Z\text{-}Ar^2)_n\text{-}CO\text{-}R^2 \qquad I$$

$$(R^1S)_m\text{-}Ar^1\text{-}CO\text{-}R^3\text{-}CO\text{-}Ar^{1'}\text{-}(R^{1'}S)_{m'} \qquad II$$

worin

$R^1$ und $R^{1'}$ jeweils Alkyl mit 1-12 C-Atomen, das durch -OH, $C_1$-$C_4$ Alkoxy, $C_2$-$C_8$ Acyloxy, -CN, ,$NH_2$, -NH-($C_1$-$C_4$)-Alkyl, -N[($C_1$-$C_4$)-Alkyl]$_2$ oder -COO-($C_1$-$C_4$) Alkyl substituiert sein kann, und/oder in dem eine dem Schwefel nicht benachbarte Methylengruppe durch -O-, -S-, -CO-, -CH=CH-, -COO- und -OCO- ersetzt sein kann,

Cycloalkyl mit 3-6 C-Atomen,
Phenylalkyl mit 7-9 C-Atomen,
Aryl mit der für $Ar^1$ angegebenen Bedeutung,
Alkanoylaryl mit der für $Ar^1$ und $R^2$ angegebenen Bedeutung,
Alkanoylarylalkyl mit der für $Ar^1$ und $R^2$ angegebenen Bedeutung,

$R^2$ Alkyl mit 1-12 C-Atomen, das durch -OH, $C_1$-$C_4$ Alkoxy, $C_2$-$C_8$ Acyloxy, -CN oder -COO-($C_1$-$C_4$) Alkyl substituiert sein kann, und/oder in dem eine der Carbonylgruppe nicht benachbarte Methylengruppe durch -O-, -S-, -CO-, -COO- oder -OCO- ersetzt sein kann,
Cycloalkyl mit 3-6 C-Atomen,
Phenylalkyl mit 7-9 C-Atomen,

$R^3$ Alkylen mit 1-6 C-Atomen, $C_2$-$C_6$ Oxaalkylen, $C_2$-$C_6$ Thiaalkylen, $C_2$-$C_6$ Azaalkylen oder Cyclohexylen,

$Ar^1$ und $Ar^{1'}$ jeweils Aryl mit 6-14 C-Atomen, Thienyl, Furyl, Pyridyl, Phenyl oder durch $C_1$-$C_4$ Alkyl, $C_1$-$C_4$ Alkoxy, Cl, Br oder CN substituiertes Phenyl bedeutet,

$Ar^2$ Phenyl oder durch $C_1$-$C_4$ Alkyl, $C_1$-$C_4$ Alkoxy, $C_1$-$C_4$ Alkylthio, Cl, Br oder CN substituiertes Phenyl,

Z -O-, -S-, $-SO_2-$, $-CH_2-$, $-C(CH_3)_2-$, -NH-, -N($C_1$-$C_6$)Alkyl-, -CH=CH-, -CO- oder eine direkte Bindung,

m und m' jeweils 1 bis 3,

n 0 oder 1 bedeutet,

gegebenenfalls mit bekannten Photoinitiatoren, als Initiatoren für die Photopolymerisation photopolymerisierbarer ungesättigter Verbindungen oder deren Gemische.

Gegenstand der Erfindung ist ferner ein photopolymerisierbares System, enthaltend mindestens eine ethylenisch ungesättigte photopolymerisierbare Verbindung sowie gegebenenfalls weitere bekannte und übliche Zusatzstoffe, das dadurch gekennzeichnet ist, daß es mindestens eine Verbindung der allgemeinen Formel I und/oder II, vorzugsweise 0,1 bis 20 Gew. % mindestens einer Verbindung der allgemeinen Formel I und/oder II, als Photoinitiator enthält.

Gegenstand der Erfindung ist auch ein Verfahren zur Photopolymerisation von ethylenisch ungesättigten Verbindungen, das dadurch gekennzeichnet ist, daß man dem zu polymerisierenden System vor der Auslösung der Photopolymerisation mindestens eine Verbindung der allgemeinen Formel I und/oder II, vorzugsweise 0,1 bis 20 Gew. % mindestens einer Verbindung der allgemeinen Formel I und/oder II, als Photoinitiator zusetzt.

In der allgemeinen Formeln I und II bedeutet $R^1$ und $R^{1'}$, die gleich oder verschieden sein können, vorzugsweise Alkyl mit 1-12 C-Atomen, Phenylalkyl mit 7-9 C-Atomen, Alkanoylaryl mit 8-15 C-Atomen, Alkanoylphenylalkyl mit 9-15 C-Atomen, Aryl mit 6-14 C-Atomen, insbesondere Alkyl mit 1-6 C-Atomen, Alkanoylaryl mit 8-10 C-Atomen, Alkanoylphenylalkyl mit 9-12 C-Atomen, Benzyl und Phenyl.

Danach können die Reste $R^1$ und $R^{1'}$ beispielsweise bedeuten Methyl, Ethyl, Propyl, 1-Methylethyl, Butyl, 1-Methylpropyl, 2-Methylpropyl, 1,1-Dimethylethyl, Pentyl, 3-Methylbutyl, 2,2-Dimethylpropyl, Hexyl, Heptyl, Octyl, Nonyl, Decyl, Undecyl, Benzyl, 1-Phenylethyl, 2-Phenylethyl, Naphthyl, Anthracenyl, Phenanthryl, Nonanoylphenyl, Octanoylphenyl, Heptanoylphenyl, Hexanoylphenyl, Pentanoylphenyl, 3-Methylbutanoylphenyl, 2,2-Dimethylpropanoylphenyl, Butanoylphenyl, 2-Methyl-propanoylphenyl, Propanoylphenyl, Acetylphenyl, Octanoylphenyl, Heptanoylphenyl, Hexanoylbenzyl, Pentanoylbenzyl, 3-Methylbutanoylbenzyl, 2,2-Dimethylpropanoylbenzyl, Butanoylbenzyl, 2-Methylpropanoylbenzyl, Propanoylbenzyl, Acetylbenzyl, Heptanoylphenylethyl, Hexanoylphenylethyl, Pentanoylphenylethyl, 3-Methylbutanoylphenylethyl, 2,2-Dimethylpropanoylphenylethyl, Butanoylphenylethyl, 2-Methylpropanoylphenylethyl, Propanoylphenylethyl, Acetylphenylethyl.

$R^2$ bedeutet vorzugsweise Alkyl mit 1-12 C-Atomen und Phenylalkyl mit 6-8 C-Atomen, insbesondere Alkyl mit 1-7 C-Atomen und Benzyl.

$R^2$ kann demnach bedeuten Methyl, Ethyl, Propyl, 1-Methylethyl, Butyl, 2-Methylpropyl, 1,1-Dimethylethyl, Pentyl, 3-Methylbutyl, Hexyl, Heptyl, 2-Ethylpentyl.

$R^3$ bedeutet vorzugsweise Alkylen mit 1-6 C-Atomen oder Cyclohexylen, insbesondere Alkylen mit 1-3 C-Atomen.

Beispielsweise bedeutet $R^3$ Methylen, Ethylen, Propylen, Methylethylen, Dimethylmethylen, 1- oder 2-Methylpropylen, Dimethylethylen, Pentylen, 2,2-Dimethylpropylen, Hexylen, Cyclohexylen.

$Ar^1$ und $Ar^{1'}$, die gleich oder verschieden sein können bedeuten bevorzugt Aryl mit 6-14 C-Atomen oder durch $C_1$-$C_4$ Alkyl, $C_1$-$C_4$ Alkoxy, Cl oder Br substituiertes Phenyl, insbesondere Phenyl oder durch $C_1$-$C_4$ Alkyl oder $C_1$-$C_4$ Alkoxy substituiertes Phenyl.

Bei mehrfacher Substitution der aromatischen Ringe $Ar^1$ und $Ar^{1'}$ sind die Substituenten vorzugsweise gleich, sie können aber auch verschieden sein. Sie befinden sich vorzugsweise in 3 und/oder 5-Stellung, sie können aber auch in 2,4 oder 6-Stellung stehen.

$Ar^2$ bedeutet bevorzugt Phenyl oder durch $C_1$-$C_4$ Alkyl oder $C_1$-$C_4$ Alkoxy substituiertes Phenyl, vorzugsweise Phenyl.

Bevorzugte Bedeutungen von Z sind O, S, $CH_2$, $C(CH_3)_2$ oder CO, insbesondere O, S und CO.

m und m' können 1 bis 3 bedeuten und gleich oder verschieden sein, von Vorteil ist m = 1.
n kann O oder 1 bedeuten, von Vorteil ist n = O.

Dementsprechend werden erfindungsgemäß insbesondere diejenigen Verbindungen der allgemeinen Formel I und/oder II bevorzugt als Photoinitiator verwendet, in denen mindestens einer der Reste $R^1$, $R^{1'}$, $R^2$, $R^3$, $Ar^1$, $Ar^{1'}$, $Ar^2$, Z, m und m' eine der vorstehend genannten bevorzugten Bedeutungen hat.
In bevorzugten Verbindungen der allgemeinen Formeln I und/oder II bedeuten

$R^1$ und $R^{1'}$ Alkyl mit 1-12 C-Atomen, Phenylalkyl mit 7-9 C-Atomen, Aryl mit 6-14 C-Atomen, Alkanoylaryl mit 8-15 C-Atomen, Alkanoylphenylalkyl mit 9-15 C-Atomen

| | |
|---|---|
| $R^2$ | Alkyl mit 1-12 C-Atomen, Phenylalkyl mit 6-8 C-Atomen, |
| $R^3$ | Alkylen mit 1-6 C-Atomen, Cyclohexylen, |
| $Ar^1$ und $Ar^{1'}$ | Aryl mit 6-14 C-Atomen, durch $C_1$-$C_4$ Alkyl, $C_1$-$C_4$ Alkoxy, Br oder Cl substituiertes Phenyl, |
| $Ar^2$ | Phenyl, durch $C_1$-$C_4$ Alkyl oder $C_1$-$C_4$ Alkoxy substituiertes Phenyl, |
| Z | O, S, $CH_2$, $C(CH_3)_2$ oder CO, |
| m und m' | 1 bis 3 |
| n | O |

Ganz besonders bevorzugt ist die Verwendung als Photoinitiatoren derjenigen Verbindungen der allgemeinen Formeln I und/oder II, in denen

| | |
|---|---|
| $R^1$ und $R^{1'}$ | Alkyl mit 1-6 C-Atomen, Benzyl, Alkanoylaryl mit 8-10 C-Atomen oder Alkanoylphenylalkyl mit 9-12 C-Atomen, |
| $R^2$ | Alkyl mit 1-7 C-Atomen oder Benzyl, |
| $R^3$ | Alkylen mit 1-3 C-Atomen, |
| $Ar^1$ und $Ar^{1'}$ | Phenyl oder durch $C_1$-$C_4$ Alkyl oder $C_1$-$C_4$ Alkoxy substituiertes Phenyl, |

| | |
|---|---|
| $Ar^2$ | Phenyl, |
| Z | O, S oder CO |
| m und m' | 1 und |
| n | O |

bedeuten.

Die Verbindungen der allgemeinen Formeln I und II können nach Standardverfahren der organischen Chemie hergestellt werden. Die Reaktionsbedingungen können den Standardwerken der präparativen organischen Chemie entnommen werden, z. B. HOUBEN-WEYL, Methoden der organischen Chemie, Georg Thieme Verlag, Stuttgart, oder ORGANIC SYNTHESES, J. Wiley, New York - London - Sydney.

Verbindungen der allgemeinen Formel I und II, in denen $R^1$, $R^{1'}$, $R^2$, $R^3$, $Ar^1$, $Ar^{1'}$, $Ar^2$, Z, m, m' und n die vorstehend angegebene Bedeutung haben, können beispielsweise hergestellt werden, indem die Alkali- oder Erdalkalisalze von Verbindungen der Formel I und II, in denen $R^1$ und $R^{1'}$ H bedeuten, in an sich üblicher Weise umgesetzt werden mit einem Halogenid der Formel $R^1$-Hal oder $R^{1'}$-Hal, worin Hal ein Halogenatom, vorzugsweise Chlor oder Brom bedeutet, oder einem Sulfonat der Formel $R^1-OSO_2R$ oder $R^{1'}-OSO_2R$, worin R $C_1$-$C_4$ Alkyl, Phenyl oder substituiertes Phenyl bedeutet sowie $R^1$ und $R^{1'}$ die oben angegebene Bedeutung haben. Die als Ausgangsmaterial verwendeten Verbindungen der Formel I und II mit $R^1 = R^{1'} = H$ können beispielsweise aus bekannten Verbindungen der Formel IIIa/b erhalten werden,

$$X\text{-}Ar^1\text{-}(Z\text{-}Ar^2)_n\text{-}CO\text{-}R^2 \qquad X\text{-}Ar^1\text{-}CO\text{-}R^3\text{-}CO\text{-}Ar^{1'}\text{-}X$$

IIIa IIIb

worin

X Cl, Br oder I bedeutet und

$Ar^1$, $Ar^{1'}$, $Ar^2$, $R^2$, $R^3$ und n die in Formel I/II angegebene Bedeutung haben,

indem man diese Halogenverbindungen nach bekannten Verfahren mit Alkali- oder Erdalkalisulfiden oder -hydrogensulfiden umsetzt.

Verbindungen der Formel IIIa/b, worin X Halogen oder $N_2^{\oplus}$ bedeutet, können mit den Alkali- oder Erdalkalisalzen von Thiolen der Formel $R^1$-SH oder $R^{1'}$-SH, wobei $R^1$ und $R^{1'}$ die in Formel I und II angegebene Bedeutung haben, direkt zu Verbindungen der Formel I und II umgesetzt werden.

Die Ausgangsstoffe der Formel IIIa/b mit $X = N_2^{\oplus}$ werden aus bekannten Verbindungen der Formel IIIa/b mit $X = NH_2$ durch Diazotierung mittels salpetriger Säure oder einem organischen Nitrit in an sich bekannter Weise erhalten.

Um zu Verbindungen der Formel I oder II zu gelangen ist es weiterhin möglich, Verbindungen der Formel IV,

$$(R^1S)_m\text{-}Ar^1\text{-}(Z\text{-}Ar^2)_n\text{-}H \qquad IV$$

 0192167

worin $R^1$, $Ar^1$, $Ar^2$, Z, m und n die für Formel I angegebene Bedeutung haben, nach Friedel-Crafts mit Carbonsäurehalogeniden der allgemeinen Formel Hal-CO-$R^2$ oder Hal-CO-$R^3$-CO-Hal in Gegenwart einer Lewissäure wie Aluminiumchlorid, Zinkchlorid oder Bortrifluorid umzusetzen, worin Hal ein Halogenatom, vorzugsweise Chlor oder Brom bedeutet und $R^2$ und $R^3$ die in Formel I und II angegebene Bedeutung haben. Gegebenenfalls ist es erforderlich etwaige Substituenten in den Resten $R^2$ oder $R^3$ mit geeigneten Schutzgruppen zu versehen und diese nach Ausführung der Friedel-Crafts-Reaktion wieder zu entfernen.

Ein weiteres Verfahren zur Herstellung von Verbindungen der Formel I und II besteht darin, daß man Verbindungen der Formel V,

$$(R^1S)_m-Ar^1-(Z-Ar^2)_n-CN \qquad V$$

worin $R^1$, $Ar^1$, $Ar^2$, Z, m und n die in Formel I angegebene Bedeutung haben, nach Grignard mit einer magnesiumorganischen Verbindung der Formel $R^2$-MgHal oder MgHal-$R^3$-MgHal umsetzt, wobei $R^2$ und $R^3$ die in Formel I und II angegebene Bedeutung haben und Hal ein Halogenatom, vorzugsweise Chlor, Brom oder Jod bedeuten.

Die Verbindungen der allgemeinen Formel I und/oder II können erfindungsgemäß als Photoinitiatoren für die Photopolymerisation ethylenisch ungesättigter Verbindungen bzw. für die Härtung photopolymerisierbarer Systeme, die solche Verbindungen enthalten, und insbesondere auch als UV-Härter für Druckfarben und bei der Strahlungshärtung wäßriger Prepolymerdispersionen verwendet werden. Diese Verwendung erfolgt in üblicher Weise. Die erfindungsgemäß anzuwendenden Verbindungen werden den zu polymerisierenden Systemen in der Regel in Mengen von 0,1 bis 20 Gew.%, vorzugsweise 0,5 bis 12 Gew.% zugesetzt.

Dieser Zusatz geschieht in der Regel durch einfaches Lösen und Einrühren, da die meisten der zu polymerisierenden Systeme und der erfindungsgemäß verwendeten Photoinitiatoren flüssig oder zumindest gut löslich sind. Unter einem zu polymerisierenden System wird ein Gemisch von durch freie Radikale initiierbaren mono- oder polyfunktionellen ethylenisch ungesättigten Monomeren, Oligomeren, Prepolymeren, Polymeren oder Mischungen dieser Oligomeren, Prepolymeren und Polymeren mit ungesättigten Monomeren verstanden, das in der Regel weitere Zusätze wie z. B. Antioxidantien, Lichtstabilisatoren, Farbstoffe, Pigmente, weitere bekannte Photoinitiatoren, Reaktionsbeschleuniger enthalten kann. Als ungesättigte Verbindungen kommen alle diejenigen infrage, deren C=C-Doppelbindungen durch z. B. Halogenatome, Carbonyl-, Cyano-, Carboxy-, Ester-, Amid-, Ether- oder Arylgruppen oder durch konjugierte weitere Doppel- oder Dreifachbindungen aktiviert sind. Beispiele für solche Verbindungen sind Vinylchlorid, Vinylidenchlorid, Acrylnitril, Methacrylnitril, Acrylamid, Methacrylamid, Methyl-, Ethyl-, n- oder tert. Butyl-, Cyclohexyl-, 2-Ethylhexyl-, Benzyl-, Phenyloxyethyl-, Hydroxyethyl-, Hydroxypropyl-, niederes Alkoxyethyl-, Tetrahydrofurfurylacrylat oder -methacrylat, Vinylacetat, -propionat, -acrylat, -succinat, N-Vinylpyrrolidon, N-Vinylcarbazol, Styrol, Divinylbenzol, substituierte Styrole, sowie die Mischungen von solchen ungesättigten Verbindungen. Auch mehrfach ungesättigte Verbindungen wie beispielsweise Ethylendiacrylat, 1,6-Hexandioldiacrylat, propoxyliertes Bisphenol-A-diacrylat und -dimethacrylat, Trimethylolpropandiacrylat und Pentaerythrittriacrylat können mit den erfindungsgemäß verwendeten Photoinitiatoren polymerisiert werden. Als photopolymerisierbare Verbindungen kommen weiterhin ungesättigte Oligomere, Prepolymere oder Polymere und deren Mischungen mit ungesättigten Monomeren in Frage. Hierzu zählen beispielsweise ungesättigte Polyester, ungesättigte Acrylmaterialien, Epoximaterialien, Urethane, Silikone, Aminopolyamid-Harze und insbesondere acrylierte Harze wie acryliertes Silikonöl, acrylierter Polyester, acrylierte Urethane, acrylierte Polyamide, acryliertes Sojabohnenöl, acryliertes Epoxiharz, acryliertes Acrylharz, zweckmäßig im Gemisch mit einem oder mehreren Acrylaten eines Mono-, Di- oder Polyalkohols.

Die photopolymerisierbaren Verbindungen oder Systeme können durch den Zusatz bekannter thermischer Inhibitoren und Antioxidantien, wie beispielsweise Hydrochinon oder Hydrochinonderivate, Pyrogallol, Thiophenole, Nitroverbindungen, ß-Naphthylamine oder ß-Naphthole in den üblichen Mengen stabilisiert werden, ohne daß dadurch die Initiatorwirkung der erfindungsgemäßen Photoinitiatoren nennenswert beeinträchtigt wird. Durch solche Zusätze soll vor allem eine vorzeitige Polymerisation während der Herstellung der Systeme durch Mischen der Komponenten verhindert werden.

Weiterhin können geringe Mengen von Lichtstabilisatoren, wie beispielsweise Benzophenon-Derivate, Benztriazol-Derivate, Tetraalkylpiperidine oder Phenylsalicylate, zugesetzt werden.

Um die inhibierende Wirkung des Luftsauerstoffs auszuschließen, setzt man photopolymerisierbaren Systemen häufig auch Paraffin oder ähnliche wachsartige Stoffe zu. Infolge mangelnder Löslichkeit im Polymeren schwimmen diese bei Beginn der Polymerisation aus und bilden eine transparente Oberflächenschicht, die den Zutritt von Luft verhindert. Der Luftsauerstoff kann beispielsweise auch durch Einführung von autoxidablen

Gruppen, wie z. B. Allylgruppen, in das zu härtende System desaktiviert werden.
Die erfindungsgemäßen Photoinitiatoren können auch in Kombination mit bekannten radikalischen Initiatoren, wie beispielsweise Peroxiden, Hydroperoxiden, Ketonperoxiden oder Percarbonsäureestern verwendet werden. Weiterhin können sie Pigmente oder Farbstoffe, wie sie z. B. in photochemisch aushärtenden Druckfarben gebräuchlich sind, enthalten. In diesem Fall wird die Photoinitiatormenge höher gewählt, beispielsweise 6 bis 12 Gew.%, während für farblose photopolymerisierbare Produkte 0,1 bis 3 Gew.% in den meisten Fällen voll ausreichen. Je nach Verwendungszweck können Füllstoffe, wie Talkum, Gips oder Kieselsäure, Fasern, organische Zusatzstoffe, wie Thixotropiemittel, Verlaufsmittel, Bindemittel, Gleitmittel, Mattierungsmittel, Weichmacher, Netzmittel, Silikone zur Verbesserung der Oberflächenbeschaffenheit, Antiausschwimmittel oder geringe Mengen an Lösungsmitteln zugesetzt werden.

Als gegebenenfalls zusammen mit den erfindungsgemäßen Initiatoren verwendbare bekannte Photoinitiatoren kommen beispielsweise infrage Benzophenone wie z. B. Michlers Keton [4,4'-Bis(dimethylamino)benzophenon], 4,4'-Bis(diäthylamino)benzophenon, p-Dimethylaminobenzophenon, p-Chlorbenzophenon, Benzophenon; Anthrachinone wie z. B. Anthrachinon, 2-Chloranthrachinon, 2-Alkylanthrachinone; Xanthone wie z. B. 2-Halogenxanthone oder 2-Alkylxanthone; Thioxanthone wie 2-Chlorthioxanthon, 2-Alkylthioxanthone; Acridanone wie z. B. 2-Alkylacridanone oder N-substituierte Acridanone; Benzoine wie z. B. p-Dimethylaminobenzoin und Alkylether des Benzoins; Benzilketale, α-Halogenketone, Dialkoxyacetophenone, α-Hydroxyalkylphenone und α-Aminoalkylphenone wie sie beispielsweise in

der DE-OS 27 22 264 und in der EP-OS 3002 beschrieben sind, weiterhin z. B. Fluorenone, Dibenzosuberone, Phenanthrenchinone, Benzoesäureester wie z. B. Hydroxypropylbenzoat, Benzoylbenzoatacrylat.

Gemische mit bekannten Initatoren enthalten die erfindungsgemäß anzuwendenden thiosubstituierten Ketone in der Regel in Anteilen von mindestens 10 Gew.% bezogen auf die Gesamtmenge an eingesetzter Initiatormischung.

Als Reaktionsbeschleuniger können beispielsweise organische Amine, Phosphine, Alkohole und/oder Thiole, die alle mindestens eine zum Heteroatom α-ständige CH-Gruppe aufweisen, zugesetzt werden. Geeignet sind z. B. primäre, sekundäre und tertiäre aliphatische, aromatische, araliphatische oder heterocyclische Amine, wie sie z. B. in der US-PS 3,759,807 beschrieben sind. Beispiele für solche Amine sind Butylamin, Dibutylamin, Tributylamin, Cyclohexylamin, Benzyldimethylamin, Di-cyclohexylamin, Triethanolamin, N-Methyldiethanolamin, Phenyl-diethanolamin, Piperidin, Piperazin, Morpholin, Pyridin, Chinolin, p-Dimethylaminobenzoesäureethylester, p-Dimethylaminobenzoesäurebutylester, 4,4'-Bis-dimethylamino-benzophenon (Michlers Keton) oder 4,4'-Bis-diethylamino-benzophenon. Besonders bevorzugt sind tertiäre Amine wie beispielsweise Trimethylamin, Tri-isopropylamin, Tributylamin, Octyldimethylamin, Dodecyl-dimethylamin, Triethanolamin, N-Methyl-diethanolamin, N-Butyl-diethanolamin, Tris-(hydroxypropyl)amin, Dimethylaminobenzoesäurealkylester.

Weiterhin kommen als Reaktionsbeschleuniger beispielsweise Trialkylphosphine, sekundäre Alkohole und Thiole in Frage.

Photopolymerisierbare Systeme, die zusätzlich als Reaktionsbeschleuniger ein tertiäres organisches Amin enthalten, stellen eine besonders bevorzugte Form der vorliegenden Erfindung dar.

Der Ausdruck "Photopolymerisation von ethylenisch ungesättigten Verbindungen" ist im weitesten Sinn zu verstehen. Darunter fällt z. B. das weitere Polymerisieren oder das Quervernetzen von polymeren Materialien, z. B. von Prepolymeren, die Homo-, Co- und Terpolymerisation von einfachen Monomeren und auch die Kombination der genannten Reaktionsarten.

Die Photopolymerisation erfolgt nach an sich bekannten Methoden durch Bestrahlen mit Licht oder UV-Strahlung des Wellenlängenbereichs von 250 bis 500 nm, vorzugsweise von 300 bis 400 nm. Als Strahlenquellen können Sonnenlicht oder künstliche Strahler verwendet werden. Vorteilhaft sind z. B. Quecksilberdampf-Hochdruck-, -Mitteldruck- oder -Niederdrucklampen, Xenon- und Wolframlampen; Laser-Lichtquellen können ebenfalls eingesetzt werden.

Verbindungen der Formel I und/oder II werden erfindungsgemäß verwendet als Photoinitiatoren bei der UV-Härtung von dünnen Schichten, wie z. B. Papier-, Kunststoff- und Metallbeschichtungen sowie der Trocknung von Druckfarben und bieten besondere Vorteile als Initiatoren für die vergilbungsfreie Härtung pigmentierter Systeme und für photohärtbare Systeme zur Herstellung von Druckplatten.

In den folgenden Beispielen werden die Herstellung und erfindungsgemäße Verwendung von Verbindungen der Formel I und II beschrieben.

A: Herstellung der Photoinitiatoren

Beispiel 1

2-Methyl-1-(4-propylthiophenyl)-propan-1-on

Zu 45,6 g (0,3 Mol) Propylthiobenzol in 120 ml Dichlormethan werden bei -10 °C unter Rühren portionsweise 48 g (0,36 Mol) wasserfreies Aluminiumchlorid zugesetzt. Anschließend tropft man bei -5 bis 0 °C 35 g (0,33 Mol) Isobuttersäurechlorid zu. Man läßt die Mischung auf Raumtemperatur erwärmen und rührt noch 2 Stunden nach. Der Ansatz wird dann in ein Gemisch aus 200 ml konzentrierter Salzsäure und 200 g Eis eingerührt und die organische Phase abgetrennt. Die wässrige Schicht wird zweimal mit je 100 ml Dichlormethan extrahiert. Man wäscht die vereinigten Phasen zuerst mit 50 ml 2 N Natronlauge, dann mit 100 ml Wasser. Anschließend wird über Natriumsulfat getrocknet. Die vom Trockenmittel befreite Lösung wird im Vakuum eingeengt. Zur Reinigung destilliert man den Rückstand im Vakuum und erhält so in 91 % d. Th. 2-Methyl-1-(4-propyl-thiophenyl)-propan-1-on.

Analog wurden die Verbindungen in Tab. 1 der allgemeinen Formel I mit m = 1, n = 0 und $Ar^1$ = 1,4-Phenylen erhalten.

Tab. 1

| $R^1$ | $R^2$ | Kp [Torr/°C] | Ausb. % | $^1$HNMR (200 MHZ, $CDCl_3$ Lösungsmittel, TMS Standard) σ [ppm] |
|---|---|---|---|---|
| i-$C_3H_7$ | $CH_3$ | 1,4/118-122 | 76 | 7,9-7,4 (m, 4H, arom. H); 3,6 (sept, 1H, CH); 2,6 (s, 3H, $CH_3$); 1,4 (d, 6H, 2$CH_3$) |
| i-$C_3H_7$ | $C_2H_5$ | 0,6/115-119 | 76 | 7,9 (d, 2H, arom. H); 7,4 (d, 2H, arom. H); 3,6 (sept, 1H, CH); 2,9 (q, 2H, $CH_2$); 1,4 (d, 6H, 2$CH_3$); 1,2 (t, 3H, $CH_3$) |
| i-$C_3H_7$ | n-$C_3H_7$ | 0,9/127-131 | 77 | 7,9-7,4 (m, 4H, arom. H); 3,5 (sept, 1H, CH); 2,9 (t, 2H, $CH_2$); 1,7 (m, 2H, $CH_2$); 1,3 (d, 6H, 2$CH_3$); 1,0 (t, 3H, $CH_3$) |
| i-$C_3H_7$ | i-$C_3H_7$ | 3/144-148 | 75 | 7,9-7,4 (m, 4H, arom. H); 3,6 (m, 2H, 2CH); 1,4 (d, 6H, 2$CH_3$); 1,2 (d, 6H, 2$CH_3$) |
| n-$C_3H_7$ | $CH_3$ | 0,4/111 | 93 | 7,9-7,4 (m, 4H, arom. H); 3,0 (t, 2H, $CH_2$); 2,6 (s, 3H, $CH_3$); 1,8 (m, 2H, $CH_2$); 1,1 (t, 3H, $CH_3$) |
| n-$C_3H_7$ | $C_2H_5$ | 0,4/118-120 | 94 | 7,9 (d, 2H, arom. H); 7,4 (d, 2H, arom. H); 3,0 (m, 4H, 2$CH_2$); 1,8 (sext, 2H, $CH_2$); 1,2 (t, 3H, $CH_3$); 1,1 (t, 3H, $CH_3$) |
| n-$C_3H_7$ | i-$C_3H_7$ | 0,4/119-120 | 91 | 7,9-7,3 (m, arom. H); 3,5 (sept, 1H, CH); 3,0 (t, 2H, $CH_2$); 1,2 (d, 6H, 2$CH_3$); 1,1 (t, 3H, $CH_3$) |
| i-$C_4H_9$ | $CH_3$ | 0,5/114-117 | 92 | 7,9-7,3 (m, 4H, arom. H); 2,9 (d, 2H, $CH_2$); 2,0 (sept, 1H, CH); 1,0 (s, 3H, $CH_3$) |
| i-$C_4H_9$ | $C_2H_5$ | 0,5/118-125 | 87 | 7,9-7,3 (m, 4H, arom. H); 2,9 (m, 4H, 2$CH_2$); 1,9 (sept, 1H, CH); 1,2 (t, 3H, $CH_3$); 1,1 (d, 6H, 2$CH_3$) |
| i-$C_4H_9$ | i-$C_3H_7$ | 0,5/122-127 | 89 | 7,9-7,3 (m, 4H, arom. H); 3,5 (sept, 1H, CH); 2,9 (d, 2H, $CH_2$); 1,9 (sept, 1H, CH); 1,2 (d, 6H, 2$CH_3$); 1,1 (d, 6H, 2$CH_3$) |
| $CH_3$ | $CH_3$ | Fp. 80-81° | 91 | 7,9-7,3 (m, 4H, arom. H); 2,6 (s, 3H, $CH_3$); 2,5 (s, 3H, $CH_3$) |
| $CH_3$ | $C_2H_5$ | Fp. 60,5-61° | 84 | 7,9-7,3 (m, 4H, arom. H); 3,0 (q, 2H, $CH_2$); 2,5 (s, 3H, $CH_3$); 1,2 (t, 3H, $CH_3$) |

Beispiel 2

Bis-(4-acetylphenyl)-sulfid

Analog der in Beispiel 1 angegebenen Arbeitsweise wird 1 Mol Diphenylsulfid mit 2 Mol Acetylchlorid und 2 Mol Aluminiumchlorid umgesetzt. Das erhaltene Produkt schmilzt nach dem Kristallisieren aus Toluol bei 89,5 - 90 °C.

$^1$H-NMR: δ 7,9 (d, 4H, arom. H); 7,4 (d, 4H, arom. H); 2,6 (s, 6H, $2CH_3$).

Analog zu Beispiel 2 werden erhalten:

Bis-(4-propionylphenyl)-sulfid
Bis-(4-butanoylphenyl)-sulfid
Bis-(4-pentanoylphenyl)-sulfid
Bis-(4-hexanoylphenyl)-sulfid
Bis-(4-heptanoylphenyl)-sulfid
Bis-(4-octanoylphenyl)-sulfid
Bis-(4-nonanoylphenyl)-sulfid
Bis-(4-decanoylphenyl)-sulfid
Bis-(4-undecanoylphenyl)-sulfid
Bis-(4-dodecanoylphenyl)-sulfid
Bis-[4-(2-ethyl-hexanoyl)-phenyl]-sulfid
Bis-[4-(2-methyl-propanoyl)-phenyl]-sulfid, Kp 188 °C/ 0,6 mm, F: 64,5-65,5°; $^1$H-NMR: δ 7,9 (d, 4H, arom. H); 7,4 (d, 4H, arom. H); 2,5 (sept, 2H, 2CH); 1,2 (d, 6H, $2CH_3$)
Bis-[4-(2,2-dimethylpropanoyl)-phenyl]-sulfid

Beispiel 3

Nach der in Beispiel 2 beschriebenen Arbeitsweise werden 33,3 g 4-Methylphenylpropylsulfid, 17,3 g Acetylchlorid und 32,0 g Aluminiumchlorid miteinander umgesetzt. Kristallisation aus n-Hexan liefert (2-Acetyl-4-methylphenyl)-propylsulfid vom F 46-46,5 °C.

$^1$H-NMR: δ 7,5 (s, 1H, arom. H.); 7,2 (s, 2H, arom. H); 2,8 (t, 2H, S-$CH_2$); 2,6 (s, 3H, $CH_3CO$); 2,4 (s, 3H, $CH_3$); 1,7 (sex, 2H, $CH_2$-$\underline{CH_2}$-$CH_3$); 1,0 (t, 3H, $\underline{CH_3}$-$CH_2$).

Auf analoge Weise werden erhalten:

4-Acetyl-diphenylsulfid
4-Propanoyl-diphenylsulfid
4-Butanoyl-diphenylsulfid
4-Pentanoyl-diphenylsulfid
4-Hexanoyl-diphenylsulfid
4-Heptanoyl-diphenylsulfid
4-Octanoyl-diphenylsulfid
4-Nonanoyl-diphenylsulfid
4-Decanoyl-diphenylsulfid
4-Undecanoyl-diphenylsulfid
4-Dodecanoyl-diphenylsulfid

4-(2-Ethyl-hexanoyl)-diphenylsulfid
4-(2-Methyl-propanoyl)-diphenylsulfid
4-(2,2-Dimethylpropanoyl)-diphenylsulfid

4-(4-Methylthio-phenoxy)-acetophenon
4-(4-Methylethylthio-phenoxy)-acetophenon
4-(4-Dimethylethylthio-phenoxy)-acetophenon
4-(4-Octylthio-phenoxy)-acetophenon
4-(4-Dodecylthio-phenoxy)-acetophenon
4-(4-Cyclopentylthio-phenoxy)-acetophenon
4-(4-Phenylthio-phenoxy)-acetophenon

4-(4-Methylthio-phenylthio)-acetophenon
4-(4-Methylethylthio-phenylthio)-acetophenon
4-(4-Dimethylethylthio-phenylthio)-acetophenon
4-(4-Octylthio-phenylthio)-acetophenon
4-(4-Dodecylthio-phenylthio)-acetophenon
4-(4-Cyclopentylthio-phenylthio)-acetophenon
4-(4-Phenylthio-phenylthio)-acetophenon

Beispiel 4

Nach der in Beispiel 1 beschriebenen Arbeitsweise werden 39,3 g Phenylmercaptoessigsäureethylester, 23,5 g Buttersäurechlorid und 64,0 g Aluminiumchlorid miteinander umgesetzt. Es wird (4-Butanoylphenylthio)essigsäureethylester erhalten; Kp 148-152°/0,3 mm; $^{1}$H-NMR: δ 7,9 (m, 2H, arom. H); 4,2 (q, 2H, $OCH_2$); 3,7 (s, 2H, $SCH_2$); 2,9 (t, 2H, $CH_2CO$); 1,7 (sex, 2H, $CH_3$-$\underline{CH_2}$-$CH_2$); 1,2 (t, 3H, $\underline{CH_3}$-$CH_2$-$CH_2$); 1,0 (t, 3H, $OCH_2\underline{CH_3}$).

Beispiel 5

Analog zu der in Beispiel 1 beschriebenen Arbeitsweise werden 33,4 g 2-Phenylmercaptoethylacetat, 20,0 g Buttersäurechlorid und 54,7 g Aluminiumchlorid miteinander umgesetzt. Man erhält (4-Butanoylphenyl)-(2-acetoxyethyl)sulfid vom F: 50-51 °C; $^{1}$H-NMR: δ 7,9 (d, 2H, arom. H); 7,4 (d, 2H, arom. H); 4,3 (t, 2H, $CH_2O$); 3,3 (t, 2H, $CH_2S$); 2,9 (t, 2H, $CH_2CO$); 2,1 (s, 3H, $CH_3CO$); 1,8 (sex, $CH_3\underline{CH_2}CH_2$); 1,0 (t, 3H, $\underline{CH_3}$ $CH_2CH_2$).

Beispiel 6

Nach der in Beispiel 1 beschriebenen Arbeitsweise werden 24,8 g Methylphenylsulfid, 21,6 g Maleinsäureanhydrid und 64,0 g Aluminiumchlorid miteinander umgesetzt. Es wird 4-Methylthiobenzoylacrylsäure erhalten; F: 159,5-162 °C (aus Essigsäureethylester); $^1H$-NMR: δ 8,0 (m, 3H, arom. H u. vinyl. H); 7,4 (d, 2H, arom. H); 6,7 (d, 1H, vinyl. H); 2,5 (s, 3H, $CH_3$).

Beispiel 7

Unter Stickstoffatmosphäre werden 17,2 g (0,225 Mol) 2-Mercaptoethanol in 250 ml wasserfreiem Dimethylsulfoxid vorgelegt und 6,8 g (0,225 Mol) Natriumhydrid in 20 % Paraffinöl portionsweise zugegeben. Danach werden 29,9 g (0,15 Mol) 4-Bromacetophenon zugegeben. Man rührt jeweils 1 h bei Raumtemperatur und dann bei 60 °C. Die Mischung wird mit 500 ml Wasser versetzt und mit 2 x 50 ml Methyl-tert.-butylether extrahiert. Die organische Phase wird über $Na_2SO_4$ getrocknet, filtriert und eingeengt. Der Rückstand von (4-Acetylphenyl)-(2-hydroxyethyl)sulfid wird aus Toluol umkristallisiert; F: 61-62°. NMR: δ 7,9 (m, 2H, arom. H); 7,4 (m, 2H, arom. H); 3,8 (t, 2H, $CH_2O$); 3,2 (t, 2H, $CH_2S$); 2,5 (s, 3H, $CH_3$).

Analog zu den Beispielen 1-7 werden erhalten:

4-(4-Methylthio-phenylsulfonyl)-acetophenon
4-(4-Methylethylthio-phenylsulfonyl)-acetophenon
4-(4-Dimethylethylthio-phenylsulfonyl)-acetophenon
4-(4-Octylthio-phenylsulfonyl)-acetophenon
4-(4-Dodecylthio-phenylsulfonyl)-acetophenon
4-(4-Cyclopentylthio-phenylsulfonyl)-acetophenon
4-(4-Phenylthio-phenylsulfonyl)-acetophenon

4-(4-Methylthio-benzyl)-acetophenon
4-(4-Methylethylthio-benzyl)-acetophenon
4-(4-Dimethylethylthio-benzyl)-acetophenon
4-(4-Octylthio-benzyl)-acetophenon
4-(4-Dodecylthio-benzyl)-acetophenon
4-(4-Cyclopentylthio-benzyl)-acetophenon
4-(4-Phenylthio-benzyl)-acetophenon

4-(4-Methylthio-phenylamino)-acetophenon
4-(4-Methylethylthio-phenylamino)-acetophenon
4-(4-Dimethylethylthio-phenylamino)-acetophenon
4-(4-Octylthio-phenylamino)-acetophenon
4-(4-Dodecylthio-phenylamino)-acetophenon
4-(4-Cyclopentylthio-phenylamino)-acetophenon
4-(4-Phenylthio-phenylamino)-acetophenon

4-(4-Methylthio-phenylamino)-acetophenon
4-(4-Methylethylthio-phenylamino)-acetophenon
4-(4-Dimethylethylthio-phenylamino)-acetophenon
4-(4-Octylthio-phenylamino)-acetophenon
4-(4-Dodecylthio-phenylamino)-acetophenon
4-(4-Cyclopentylthio-phenylamino)-acetophenon
4-(4-Phenylthio-phenylamino)-acetophenon

4-(4-Methylthiophenyl)-acetophenon
4-(4-Methylethylthiophenyl)-acetophenon
4-(4-Dimethylethylthiophenyl)-acetophenon
4-(4-Octylthiophenyl)-acetophenon
4-(4-Dodecylthiophenyl)-acetophenon
4-(4-Cyclopentylthiophenyl)-acetophenon
4-(4-Phenylthiophenyl)-acetophenon

4-(4-Methylthio-benzoyl)-acetophenon
4-(4-Methylethylthio-benzoyl)-acetophenon
4-(4-Dimethylethylthio-benzoyl)-acetophenon
4-(4-Octylthio-benzoyl)-acetophenon
4-(4-Dodecylthio-benzoyl)-acetophenon
4-(4-Cyclopentylthio-benzoyl)-acetophenon
4-(4-Phenylthio-benzoyl)-acetophenon

1-(4-Acetylphenyl)-2-(4-methylthiophenyl)-ethen
1-(4-Acetylphenyl)-2-(4-methylethylthiophenyl)-ethen
1-(4-Acetylphenyl)-2-(4-dimethylethylthiophenyl)-ethen
1-(4-Acetylphenyl)-2-(4-octylthiophenyl)-ethen
1-(4-Acetylphenyl)-2-(4-dodecylthiophenyl)-ethen
1-(4-Acetylphenyl)-2-(4-cyclopentylthiophenyl)-ethen
1-(4-Acetylphenyl)-2-(4-phenylthiophenyl)-ethen

Bis-(4-methylthiobenzoyl)-methan
Bis-(4-methylethylthiobenzoyl)-methan
Bis-(4-dimethylethylthiobenzoyl)-methan
Bis-(4-octylthiobenzoyl)-methan
Bis-(4-dodecylthiobenzoyl)-methan
Bis-(4-cyclopentylthiobenzoyl)-methan
Bis-(4-phenylthiobenzoyl)-methan

1,3-Bis-(4-methylthiobenzoyl)-propan
1,3-Bis-(4-methylethylthiobenzoyl)-propan
1,3-Bis-(4-dimethylethylthiobenzoyl)-propan
1,3-Bis-(4-octylthiobenzoyl)-propan
1,3-Bis-(4-dodecylthiobenzoyl)-propan
1,3-Bis-(4-cyclopentylthiobenzoyl)-propan
1,3-Bis-(4-phenylthiobenzoyl)-propan

Bis-(4-methylthiophenacyl)-ether
Bis-(4-methylethylthiophenacyl)-ether
Bis-(4-dimethylethylthiophenacyl)-ether
Bis-(4-octylthiophenacyl)-ether
Bis-(4-dodecylthiophenacyl)-ether
Bis-(4-cyclopentylthiophenacyl)-ether
Bis-(4-phenylthiophenacyl)-ether

Bis-[2-(4-methylthiobenzoyl)-ethyl]-sulfid
Bis-[2-(4-methylethylthiobenzoyl)-ethyl]-sulfid
Bis-[2-(4-dimethylethylthiobenzoyl)-ethyl]-sulfid
Bis-[2-(4-octylthiobenzoyl)-ethyl]-sulfid
Bis-[2-(4-dodecylthiobenzoyl)-ethyl]-sulfid
Bis-[2-(4-cyclopentylthiobenzoyl)-ethyl]-sulfid
Bis-[2-(4-phenylthiobenzoyl)-ethyl]-sulfid

Bis-[2-(4-methylthiobenzoyl)-ethyl]-amin
Bis-[2-(4-methylethylthiobenzoyl)-ethyl]-amin
Bis-[2-(4-dimethylethylthiobenzoyl)-ethyl]-amin
Bis-[2-(4-octylthiobenzoyl)-ethyl]-amin
Bis-[2-(4-dodecylthiobenzoyl)-ethyl]-amin
Bis-[2-(4-cyclopentylthiobenzoyl)-ethyl]-amin
Bis-[2-(4-phenylthiobenzoyl)-ethyl]-amin

B: Verwendung der Photoinitiatoren

Beispiel 8

Ein UV-härtbares Bindemittelsystem, das aus 75 Gew.-Teilen eines oligomeren Epoxidacrylates (Laromer® LR 8555 der Fa. BASF) und 25 Gew.-Teilen Hexandioldiacrylat besteht, wird mit verschiedenen Mengen 4-Isopropylthiopropiophenon bzw. als Vergleich mit Benzophenon versetzt. Als Coinitiator werden beiden Photoinitiatoren 3 Gew.-Teile N-Methyldiethanolamin zugesetzt.

Proben der gebrauchsfertigen Formulierungen werden auf entfetteten Glasplatten (10 x 10 cm) mit Spiralrakeln in einer Dicke von 50 µm und von 12 µm aufgebracht. Anschließend werden die Beschichtungen in einem Bestrahlungsgerät ("Mini-Cure"-Gerät der Fa. Primarc Ltd.) unter einer Quecksilbermitteldrucklampe (Lampenleistung 80 Watt/cm) mit einer Bandgeschwindigkeit von 10 m/min gehärtet. Der Belichtungsabstand beträgt ca. 10 cm.

Die Beschaffenheit der Lackoberfläche wird unmittelbar nach dem Härtungsversuch sensorisch ermittelt; dabei wird geprüft, ob die Oberfläche trocken oder klebrig ist. Die Härte der Beschichtungen wird etwa 20 Stunden nach der UV-Härtung nach DIN 53157 (Pendelhärte nach König) gemessen.

Die Ergebnisse der UV-Härtungsversuche sind in Tab. 1 zusammengefaßt.

Tab. 1

| Photoinitiator | Initiatorkonzentration in % | | | | | | | |
|---|---|---|---|---|---|---|---|---|
| | 2 | 4 | 6 | 8 | 10 | 12 | 15 | Anm. |
| 4-Isopropylthio-propiophenon | 102 | 103 | 88 | 88 | 90 | 83 | 69 | (a) |
| mit jeweils 3 % NMDEA (c) | + | + | + | + | + | + | + | (b) |
| Benzophenon | 52 | 52 | 50 | 52 | 39 | 48 | 46 | (a) |
| mit jeweils 3 % NMDEA (c) | + | + | + | + | + | + | + | (b) |

Anmerkungen (a) = Pendelhärte nach König in Sekunden, etwa 20 Stunden nach der UV-Härtung gemessen.

(b) = Beschaffenheit der Oberfläche, unmittelbar nach der Härtung ermittelt (dabei gilt: + = Oberfläche ist trocken; (+) = Oberfläche ist nicht ganz trocken; - = Oberfläche ist klebrig).

(c) NMDEA = N-Methyldiethanolamin

Die bei Anwendung des erfindungsgemäßen Photoinitiators 4-Isopropylthiopropiophenon erhaltenen gehärteten Beschichtungen sind völlig farblos, wogegen die mit Benzophenon versetzten Formulierungen nach der Strahlungshärtung in Abhängigkeit von der zugesetzten Initiatormenge eine gelbe bis dunkelgelbe Verfärbung aufweisen.

Beispiel 9

Ein Bindemittelsystem nach Beispiel 8 wird mit 2 Gew.-Teilen 4-Isopropylthiopropiophenon und 3 Gew.-Teilen N-Methyldiethanolamin bzw. 2 Gew.-Teilen Benzophenon und 3 Gew.-Teilen N-Methyldiethanolamin versetzt.

Proben der gebrauchsfertigen, UV-härtbaren Muster werden auf entfetteten Glasplatten (10 x 10 cm) mit einer Spiralrakel in einer Dicke von 50 µm aufgebracht. Anschliessend werden die Beschichtungen in einem Bestrahlungsgerät ("Mini-Cure"-Gerät der Fa. Primarc Ltd.) unter einer Quecksilbermitteldrucklampe (Lampenleistung 80 Watt/cm) mit einer Bandgeschwindigkeit von 5 m/min bis 100 m/min gehärtet. Der Belichtungsabstand beträgt ca. 10 cm.

Die Beschaffenheit der Filmoberfläche wird unmittelbar nach dem Härtungsversuch sensorisch ermittelt. Dabei wird geprüft, ob die Oberfläche trocken, nicht ganz trokken oder klebrig ist. Die Härte der Beschichtungen wird etwa 20 Stunden nach der UV-Härtung nach DIN 53157 (Pendelhärte nach König) gemessen.

Die Ergebnisse der UV-Härtungsversuche sind in Tab. 2 zusammengestellt. Es ist zu erkennen, daß bei der vorgegebenen Initiatorkonzentration bei einer Initiierung mit erfindungsgemäßem 4-Isopropylthio-propiophenon stets härtere Beschichtungen erhalten werden als bei einer Initiierung mit Benzophenon. Es ist außerdem zu erkennen, daß bei einer Initiierung mit 4-Isopropylthio-propiophenon mit Bandgeschwindigkeiten bis 50 m/min gefahren werden kann, um Beschichtungen mit einer trockenen, klebfreien Oberfläche zu erhalten. Bei einer Initiierung mit Benzophenon kann demgegenüber nur mit maximal 20 m pro Minute gehärtet werden, um derartige Schichten zu erhalten.

| Initiator- | Bandgeschwindigkeiten in m/min | | | | | | | | | | |
|---|---|---|---|---|---|---|---|---|---|---|---|
| system | 5 | 10 | 15 | 20 | 30 | 40 | 50 | 60 | 80 | 100 | |
| 2 % 4-Isopropylthio-propiophenon + | 189 | 159 | 145 | 127 | 111 | 84 | 73 | 56 | 35 | x | (a) |
| 3 % NMDEA (c) | + | + | + | + | + | + | + | (+) | (+) | - | (b) |
| 2 % Benzophenon + | 160 | 92 | 74 | 57 | 29 | 21 | x | | | | (a) |
| 3 % NMDEA (c) | + | + | + | + | (+) | _ | | | | | (b) |

Anmerkungen (a) = Pendelhärte nach König in Sekunden, etwa 20 Stunden nach der UV-Härtung gemessen.

(b) = Beschaffenheit der Oberfläche, unmittelbar nach der Härtung beurteilt (dabei gilt: + = Oberfläche ist trocken; (+) = Oberfläche ist nicht ganz trocken; - = Oberfläche ist klebrig).

(c) NMDEA = N-Methyldiethanolamin

x = eine Durchhärtung ist nicht möglich

Mit erfindungsgemäßem 4-Isopropylthiopropiophenon initierte Beschichtungen zeigen nach erfolgter Strahlungshärtung keine Verfärbung, wogegen die Verwendung von Benzophenon als Photoinitiator stets zu Gelbfärbungen führt.

Beispiel 10

63,5 Teilen eines Epoxidacrylatharzes (Laromer® 8555 der Firma BASF, Ludwigshafen) werden mit 36,5 Teilen Butandioldiacrylat und 20 Teilen Heliogenblau auf einer Dreiwalze angerieben. Innerhalb von 10 Minuten werden 5 Teile Bis-(4-acetylphenyl)-sulfid und 5 Teile n-Methyldiethanolamin bei 50° in die Suspension eingerührt. Die so erhaltene Druckfarbe wird in 1 µm Schichtdicke auf Kunstdruckpapier verdruckt und im Minicure-Gerät (der Firma Primarc (England)) bei einer Bandgeschwindigkeit von 50 m/Min mit einer Strahlungsleistung von 160 W/cm ausgehärtet. Die erhaltenen Druckbogen sind sofort stapelfähig. Der Farbabstandsbewertung zufolge zeigt die blaue Bedruckung keine durch Vergilbung hervorgerufene Farbverschiebung.

Analog Beispiel 10 können die in den Beispielen 1 bis 7 genannten Photoinitiatoren als UV-Härter für Druckfarben verwendet werden.

Beispiel 11

63,5 Teile eines Urethanacrylat-Harzes (Uvimer® 530 der Firma Bayer, Leverkusen) werden mit 36,5 Teilen Butandioldiacrylat und 100 Teilen Titandioxid (Anatas) in einer Porzellankugelmühle vermahlen. Anschließend werden 8,5 Teile einer Lösung aus 2,5 Teilen 2-Methyl-1-(4-propylthiophenyl)-propan-1-on und 5 Teilen 1-Phenyl-2-hydroxy-2-methyl-propan-1-on zusammen mit 3 Teilen N-Methyldiethanolamin eingerührt. Der in einer Schichtdicke von 10 µm auf Glasplatten aufgebrachte Lack läßt sich bei einer Bandgeschwindigkeit von 50 m/Min und mit einer Strahlungsleistung von 160 W/cm zu einem vergilbungsfreien Film aushärten.

Analog Beispiel 11 können die in den Beispielen 1 bis 8 genannten Verbindungen als Photoinitiatoren in einen Lack eingearbeitet werden.

Merck Patent Gesellschaft
mit beschränkter Haftung

6100 D a r m s t a d t

Patentansprüche

1. Verwendung mindestens eines thiosubstituierten Ketons der allgemeinen Formeln I und/oder II,

$$(R^1S)_m\text{-}Ar^1\text{-}(Z\text{-}Ar^2)_n\text{-}CO\text{-}R^2 \qquad I$$

$$(R^1S)_m\text{-}Ar^1\text{-}CO\text{-}R^3\text{-}CO\text{-}Ar^{1'}\text{-}(R^{1'}S)_{m'} \qquad II$$

worin

$R^1$ und $R^{1'}$ jeweils Alkyl mit 1-12 C-Atomen, das durch -OH, $C_1$-$C_4$ Alkoxy, $C_2$-$C_8$ Acyloxy, -CN, $-NH_2$, -NH-($C_1$-$C_4$)-Alkyl, -N[($C_1$-$C_4$)-Alkyl]$_2$ oder -COO-($C_1$-$C_4$)Alkyl substituiert sein kann, und/oder in dem eine dem Schwefel nicht benachbarte Methylengruppe durch -O-, -S-, -CO-, -CH=CH-, -COO- und -OCO- ersetzt sein kann, Cycloalkyl mit 3-6 C-Atomen, Phenylalkyl mit 7-9 C-Atomen, Aryl mit der für $Ar^1$ angegebenen Bedeutung, Alkanoylaryl mit der für $Ar^1$ und $R^2$ angegebenen Bedeutung, Alkanoylarylalkyl mit der für $Ar^1$ und $R^2$ angegebenen Bedeutung,

| | |
|---|---|
| $R^2$ | Alkyl mit 1-12 C-Atomen, das durch -OH, $C_1$-$C_4$ Alkoxy, $C_2$-$C_8$ Acyloxy, -CN oder -COO-($C_1$-$C_4$) Alkyl substituiert sein kann, und/oder in dem eine der Carbonylgruppe nicht benachbarte Methylengruppe durch -O-, -S-, -CO-, -COO- oder -OCO- ersetzt sein kann, Cycloalkyl mit 3-6 C-Atomen, Phenylalkyl mit 7-9 C-Atomen, |
| $R^3$ | Alkylen mit 1-6 C-Atomen, $C_2$-$C_6$ Oxaalkylen, $C_2$-$C_6$ Thiaalkylen, $C_2$-$C_6$ Azaalkylen oder Cyclohexylen, |
| $Ar^1$ und $Ar^{1'}$ | jeweils Aryl mit 6-14 C-Atomen, Thienyl, Furyl, Pyridyl, Phenyl oder durch $C_1$-$C_4$ Alkyl, $C_1$-$C_4$ Alkoxy, Cl, Br oder CN substituiertes Phenyl bedeutet, |
| $Ar^2$ | Phenyl oder durch $C_1$-$C_4$ Alkyl, $C_1$-$C_4$ Alkoxy, $C_1$-$C_4$ Alkylthio, Cl, Br oder CN substituiertes Phenyl, |
| Z | -O-, -S-, $-SO_2-$, $-CH_2-$, $-C(CH_3)_2-$, -NH-, -N($C_1$-$C_6$)Alkyl-, -CH=CH-, -CO- oder eine direkte Bindung, |
| m und m' | jeweils 1 bis 3, |
| n | O oder 1 bedeutet, |

gegebenenfalls mit bekannten Photoinitiatoren, als Initiatoren für die Photopolymerisation photopolymerisierbarer ungesättigter Verbindungen oder deren Gemische.

2. Verwendung von Verbindungen nach Anspruch 1 als Photoinitiatoren für die Photopolymerisation ethylenisch ungesättigter Verbindungen.

3. Verwendung nach Anspruch 1 in UV-härtenden Druckfarben.

4. Verwendung nach Anspruch 1 bei der Strahlungshärtung wäßriger Prepolymerdispersionen.

5. Photopolymerisierbares System, enthaltend mindestens eine ethylenisch ungesättigte photopolymerisierbare Verbindung sowie gegebenenfalls weitere bekannte und übliche Zusatzstoffe, dadurch gekennzeichnet, daß es eine Verbindung nach Anspruch 1 als Photoinitiator enthält.

6. Photopolymerisierbares System nach Anspruch 5, dadurch gekennzeichnet, daß es 0,1 bis 20 Gew. % einer Verbindung nach Anspruch 1 als Photoinitiator enthält.

7. Verfahren zur Photopolymerisation von ethylenisch ungesättigten Verbindungen, dadurch gekennzeichnet, daß man dem zu polymerisierenden Gemisch vor der Auslösung der Photopolymerisation eine Verbindung nach Anspruch 1 als Photoinitiator zusetzt.

8. Verfahren nach Anspruch 7, dadurch gekennzeichnet, daß man dem zu polymerisierenden Gemisch vor der Auslösung der Photopolymerisation 0,1 bis 20 Gew. % einer Verbindung nach Anspruch 1 als Photoinitiator zusetzt.

Europäisches Patentamt

# EUROPÄISCHER RECHERCHENBERICHT

0192167

Nummer der Anmeldung

EP 86 10 1721

| EINSCHLÄGIGE DOKUMENTE | | | |
|---|---|---|---|
| Kategorie | Kennzeichnung des Dokuments mit Angabe, soweit erforderlich, der maßgeblichen Teile | Betrifft Anspruch | KLASSIFIKATION DER ANMELDUNG (Int Cl 4) |
| X | EP-A-0 005 530 (CIBA-GEIGY)<br>* Anspruch 1 *<br>--- | 1-8 | C 08 F 2/50<br>G 03 C 1/68 |
| X | DE-A-2 155 000 (BAYER)<br>* Anspruch 1 *<br>--- | 1-8 | |
| X | FR-A-2 338 952 (BASF)<br>* Anspruch 1 *<br>----- | 1-8 | |
| | | | RECHERCHIERTE SACHGEBIETE (Int Cl 4) |
| | | | C 08 F<br>G 03 C |

Der vorliegende Recherchenbericht wurde für alle Patentansprüche erstellt

| Recherchenort | Abschlußdatum der Recherche | Prüfer |
|---|---|---|
| DEN HAAG | 28-05-1986 | CAUWENBERG C.L.M. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument